# EUROPEAN PATENT APPLICATION

(11) **EP 1 302 983 A1**
(43) Date of publication of application: **16.04.2003**
(21) Application number: 01308738.2
(22) Date of filing: 15.10.2001
(51) Int. Cl.: H01L 23/495

(54) **Leadframe having slots in a die pad**

(71) Applicant: Siliconix (Taiwan) Ltd., Kaohsiung City (TW)
(72) Inventor: Kuo, Frank, Lin-Ya Dist., Kaohsiung City (TW); Mao, Sen, Tso-Ying, Dist., Kaohsiung City (TW); Kuo, Sam, Ping-Tung City (TW); Ou, Oscar, Nan-Tze Dist., Kaohsiung City (TW)
(74) Representative: Barlow, Roy James

(57) **Abstract**

The present invention relates to a die pad of a leadframe. The die pad is used for receiving a die. The die and the die pad are connected by a solder paste. The die pad comprises a plurality of slots. The slots extend through the die pad. A restrictive region is defined by the slots such that the solder paste is restricted within the restrictive region. The die is positioned on the restrictive region. Because of the cohesion of the solder paste, the solder paste does not flow into the slots. Therefore, the solder paste does not flow and expand everywhere during the heating process. The solder paste is restricted within the restrictive region so that the die on the solder paste does not drift so as to increase the packaging quality.

## Description

### BACKGROUND OF THE INVENTION

### 1. Field of the invention

The present invention relates to a leadframe for packaging semiconductor, more particularly, to a leadframe having slots in a die pad.

### 2. Description of the Related Art

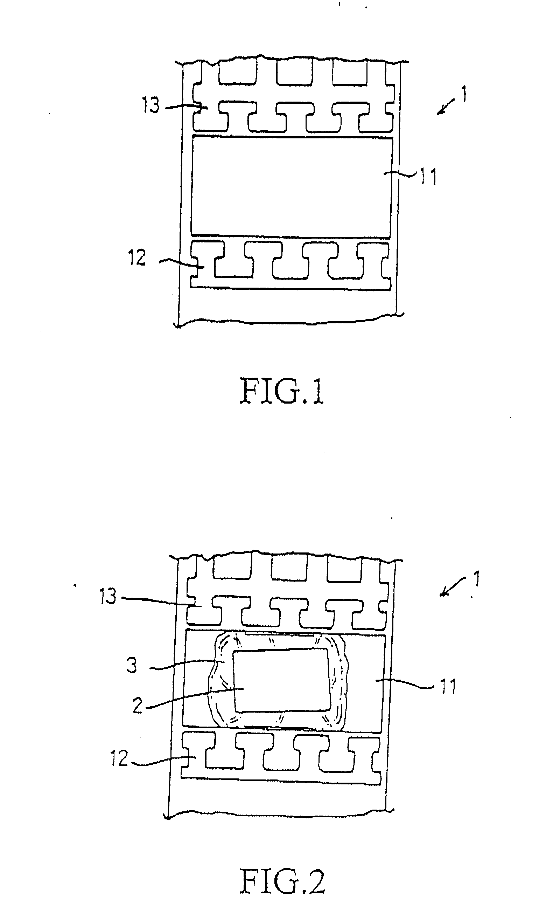

As shown in Fig. 1, a conventional leadframe 1 comprises a die pad 11 and a plurality of pins 12, 13. The die pad 11 is used for receiving a die. In conventional packaging technique of a power transistor, for the sake of dissipating heat from the power transistor, the area of the die pad 11 usually larger than that of the die.

Referring to Fig. 2, the die pad 11 receives a die 2, and the die 2 is connected to the die pad 11 with a solder paste 3. The solder paste 3 usually is made of tin or silver. When the solder paste 3 is tin, the solder paste 3 must be heated during the packaging process. In the heating process, the solder paste 3 will expand on the die pad such that the die 2 on the solder paste 3 will drift due to the movement of the melted solder paste 3. Therefore, the die 2 cannot be positioned precisely on the die pad 11. That will lower the quality of packaging the semiconductor.

Therefore, it is desirable to provide a creative and improved die pad of a leadframe to overcome the above problem.

### SUMMARY OF THE INVENTION

One objective of the present invention is to provide a die pad of a leadframe. The die pad is used for receiving a die. The die and the die pad are connected together by a solder paste. The die pad comprises a plurality of slots. The slots are penetrating through the die pad. A restrictive region is formed between the slots such that the solder paste is restricted within the restrictive region. The die can be positioned on the restrictive region. Because of the cohesion of the solder paste, the solder paste does not flow into the slots. Therefore, the solder paste does not flow and expand everywhere during the heating process. The solder paste is restricted within the restrictive region so that the die on the solder paste does not shaft so as to increase the packaging quality.

### BRIEF DESCRIPTION OF THE DRAWINGS

Fig. 1 shows a conventional leadframe.
Fig. 2 shows a conventional leadframe having a die thereon.
Fig. 3 shows a leadframe according to the first embodiment of the invention.
Fig. 4 shows a leadframe having a die thereon according to the first embodiment of the invention.
Fig. 5 shows a leadframe according to the second embodiment of the invention.
Fig. 6 shows a leadframe according to the third embodiment of the invention.

### DETAILED DESCRIPTION OF THE INVENTION

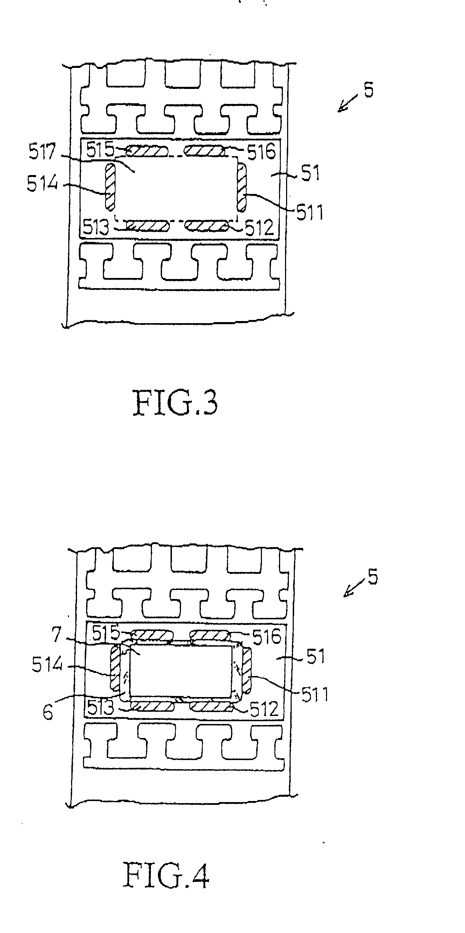

Referring to Fig. 3, according to the first embodiment of the invention, a die pad 51 of a leadframe 5 comprises a plurality of slots 511, 512, 513, 514, 515 and 516, The slots 511, 512, 513, 514, 515 and 516 extend through the die pad 51. A restrictive region 517 with a special shape (for example, rectangle) is defined by the slots 511, 512, 513, 514, 515 and 516, and is indicated with dotted lines in Fig. 3. In other words, the slots 511, 512, 513, 514, 515 and 516 are located at the periphery of the restrictive region 517.

Referring to Fig. 4, there is a solder paste 6 on the restrictive region 517 of the die pad 51. A die 7 is mounted on the solder paste 6. The die 7 and the die pad 51 are connected by the solder paste 6. The area of the restrictive region 517 is almost equal to the area of the die 7.

Because of the cohesion of the solder paste 6, the solder paste 6 does not flow into the slots 511, 512, 513, 514, 515 and 516. Therefore, the solder paste 6 (tin) does not flow and expand everywhere during the heating process. The solder paste 6 is restricted within the restrictive region 517 so that the die 7 on the solder paste 6 does not drift and is positioned on the restrictive region 517 of the die pad 51 so as to increase the packaging quality.

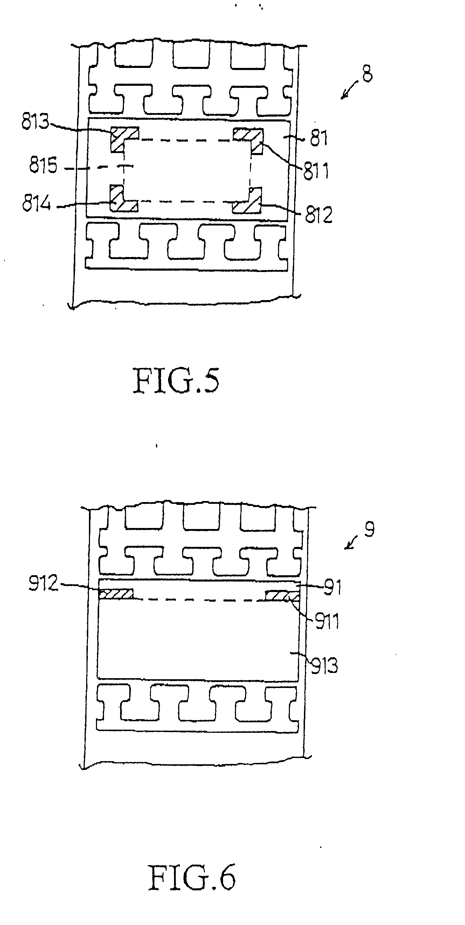

Referring to Fig. 5, according to the second embodiment of the invention, a die pad 81 of a leadframe 8 comprises a plurality of slots 811, 812, 813 and 814. The slots 811, 812, 813 and 814 extend through the die pad 81. A rectangular restrictive region 815 is defined by the slots 811, 812, 813 and 814, and is indicated with dotted lines in Fig. 5. The slots 811, 812, 813 and 814 are located at the four corners of the restrictive region 815. Similarly, the slots 811, 812, 813 and 814 can restrict the solder paste within the restrictive region 815.

Referring to Fig. 6, according to the third embodiment of the invention, a die pad 91 of a lead frame 9 comprises two slots 911 and 912. The slots 911 and 912 extend through the die pad 91. In the third embodiment, the die is larger, and the length of the die is almost equal to that of the die pad 91. The slots 911 and 912 are located in the horizontal direction. A rectangular restrictive region 913 is defined by the slots 911, 912 and the periphery of the die pad 91, and is indicated with dotted lines in Fig. 6. That is, the slots 911 and 912 are located at one side of the restrictive region 913. The slots 911 and 912 also can restrict the solder paste within the restrictive region 913.

While embodiments of the present invention have been illustrated and described, various modifications and improvements can be made by those skilled in the art. The embodiments of the present invention are therefore described in an illustrative but not restrictive sense. It is intended that the present invention is not limited to the particular forms as illustrated, and that all the modifications not departing from the spirit and scope of the present invention are within the scope as defined in the appended claims.

## Claims

1. A die pad of a leadframe, the die pad for receiving a die, the die pad comprising:
a plurality of slots penetrating the die pad and having a restrictive region defined by the slots, whereby a solder paste for connecting the die with the die pad is restricted within the restrictive region.

2. The die pad as claimed in Claim 1, wherein the area of the restrictive region is equal to the area of the die.

3. The die pad as claimed in Claim 1, wherein the slots are located at at least one side of the restrictive region.

4. The die pad as claimed in Claim 1, wherein the slots are located at at least one corner of the restrictive region.

5. A leadframe comprising a plurality of die pads and a plurality of pins, wherein the die pad is used for receiving a die, **characterized in that** each die pad comprises:
a plurality of slots penetrating the die pad and having a restrictive region defined by the slots, whereby a solder paste for connecting the die with the die pad is restricted within the restrictive region.
